# EUROPÄISCHE PATENTSCHRIFT

(11) **EP 0 492 295 B1**
(45) Veröffentlichungstag und Bekanntmachung des Hinweises auf die Patenterteilung: **08.03.1995**
(21) Anmeldenummer: 91121292.6
(22) Anmeldetag: 12.12.1991
(51) Int. Cl.: H01J 37/05

(54) **Elektronenenergiefilter, vorzugsweise vom Alpha- oder Omega-Typ**
Electron energy filter, preferably from alpha or omega type
Filtre en énergie pour électrons, de préférence du type en alpha ou en oméga

(30) Priorität: 22.12.1990 DE 4041495
(43) Veröffentlichungstag der Anmeldung: 01.07.1992
(73) Patentinhaber: Firma Carl Zeiss, D-73446 Oberkochen (DE); CARL-ZEISS-STIFTUNG, HANDELND ALS CARL ZEISS, D-73446 Oberkochen (DE)
(72) Erfinder: Krahl, Dieter, Dr., W-1000 Berlin 45 (DE); Rilk, Albrecht, W-7923 Königsbronn (DE); Pätzold, Hans, W-1000 Berlin 22 (DE); Bihr, Johannes, W-7080 Aalen (DE)

(56) Entgegenhaltungen:
- EP-A- 0 218 920
- EP-A- 0 218 921
- US-A- 3 681 599
- OPTIK. Bd. 73, Nr. 2, Mai 1986, STUTTGART DE S. LANIO ET AL.: 'Test and improved design of a corrected imaging magnetic energy filter.'

## Beschreibung

Die vorliegende Erfindung betrifft ein Elektronenenergiefilter, vorzugsweise vom Alpha- oder Omega-Typ, nach dem Oberbegriff des Anspruches 1.

Abbildende Elektronenenergiefilter, auch Elektronenfilter, Energiefilter oder Elektronen(energie)spektrometer genannt, werden bei Transmissions-Elektronenmikroskopen verwendet, um den Kontrast der Objektabbildung durch die Auswahl von Elektronen eines bestimmten Energiebereiches zu verbessern, sowie Elementverteilungsbilder und gefilterte Elektronenbeugungsdiagramme zu registrieren. Ein Alpha-Filter ist aus der EP-A2-0 218 921, ein Omega-Filter aus der EP-A2-0 218 920 bekannt.

Derartige Filter bestehen aus Magneten mit Polschuhen unter- und oberhalb einer Symmetrieebene, in welcher die Achsenlinie des Elektronenstrahlbündels geführt wird. Zwischen den Polschuhpaaren werden homogene Magnetfelder erzeugt, die den Elektronenstrahl mehrmals so umlenken, daß seine Achsenlinie beim Alpha-Filter ungefähr einem kleinen griechischen Alpha und beim Omega-Filter einem großen griechischen Omega entspricht.

Da in den Magnetfeldern die Umlenkradien der Elektronen von ihren Geschwindigkeiten abhängen, erhält man nach dem Filter ein Energie-Spektrum der transmittierten Elektronen, aus dem man einen Bereich ausblenden kann.

Meist bestehen derartige Elektronenenergiefilter aus mehreren getrennten Magnetfeldern bzw. Umlenkbereichen, die durch mehr oder weniger große Abstände mit feldfreien Bereichen voneinander getrennt sind. In diesen verläuft der Elektronenstrahl zwischen Abschirmplatten geradlinig. In den oben genannten Veröffentlichungen ist eine Ausführungsform beschrieben, bei welcher die Polschuhe ein gemeinsames Teil mit den Abschirmplatten bilden, derart daß die Filter aus zwei spiegelbildlich symmetrischen Teilen zusammengesetzt werden, in welche die Polschuhe und die erforderlichen Kanäle für den Elektronenstrahl eingearbeitet sind. Auf diese Weise wird zwar ein einfacher Aufbau und eine sehr gute Stabilität der Filter erreicht; es hat sich jedoch herausgestellt, daß ein derartiger mechanischer Aufbau ausgesprochen teuer ist, wenn die erforderlichen Genauigkeiten in den mechanischen Abmessungen eingehalten werden.

Der vorliegenden Erfindung liegt daher die Aufgabe zugrunde, einen Aufbau für Elektronenenergiefilter anzugeben, der bei verhältnismäßig geringem Aufwand eine ausreichende mechanische Genauigkeit zuläßt.

Die gestellte Aufgabe wird erfindungsgemäß einerseits durch den kennzeichnenden Teil des Anspruches 1 und andererseits durch den kennzeichnenden Teil des unabhängigen Anspruches 2 gelöst.

Es ist vorteilhaft, das Elektronenfilter aus zwei oder vier Bereichen aufzubauen, die durch Spalte aus nichtmagnetischem Material oder durch Luft- bzw. Vakuumspalte getrennt sind.

Es ist bekannt, bei einem Omega-Filter zwischen dem zweiten und dritten Polschuhpaar einen Hexapol für Korrekturzwecke anzuordnen. Als besonders vorteilhaft sowohl für die Korrektur als auch zur Justierung hat sich herausgestellt, dem Hexapolfeld ein Quadrupolfeld zu überlagern, das durch Zusatzwicklungen auf vier von den sechs Stromspulen des Hexapols erzeugt wird.

Es ist vorteilhaft, die Kanäle zwischen den Polschuhpaaren bis an die äußere Begrenzung der Platten auszubilden und an der äußeren Begrenzung Leuchtschirme oder Detektionssysteme für Justier- oder Meßzwecke anbringen zu können.

Es ist ebenfalls vorteilhaft, in Richtung der elektronenoptischen Achse des Elektronenstrahlgerätes einen Kanal vorzusehen. Er dient dem freien Durchgang des Elektronenstrahls bei ausgeschaltetem Energiefilter, z.B. zur Justierung des Elektronenstrahlgerätes.

In einer weiteren vorteilhaften Ausgestaltung der Erfindung besitzen die um die Polschuhe angeordneten Stromspulen Haupt- und Nebenwicklungen, wobei die Hauptwicklungen in Reihe geschaltet sind und die Nebenwicklungen nach Bedarf einzeln oder in Kombination geschaltet werden, um magnetische Ungleichmäßigkeiten der einzelnen Polschuhe zu korrigieren.

In einer besonders vorteilhaften Ausführungsform ist das aus Platten zusammengesetzte Filter als Funktionseinheit justierbar an einen Vakuumflansch befestigt und mit diesem in ein Korpuskularstrahlgerät einsetzbar. Die justierbare Befestigung kann z.B. über eine Parallelogrammführung aus Stäben und Verstelleinrichtungen oder aus einen Kreuztisch bestehen.

Die Erfindung wird im folgenden anhand von in den Figuren 1 bis 4 dargestellten Ausführungsbeispielen näher erläutert. Dabei zeigen
- Fig. 1: ein Elektronenenergiefilter aus drei Platten, dargestellt in zwei Schnitten,
- Fig. 2: ein Elektronenenergiefilter aus vier Platten, dargestellt in zwei Schnitten,
- Fig. 3: einen Schnitt durch ein Elektronenenergiefilter mit zwei Bereichen und
- Fig. 4: eine parallelogrammartige Befestigung des Elektronenenergiefilters, dargestellt in zwei Schnitten.

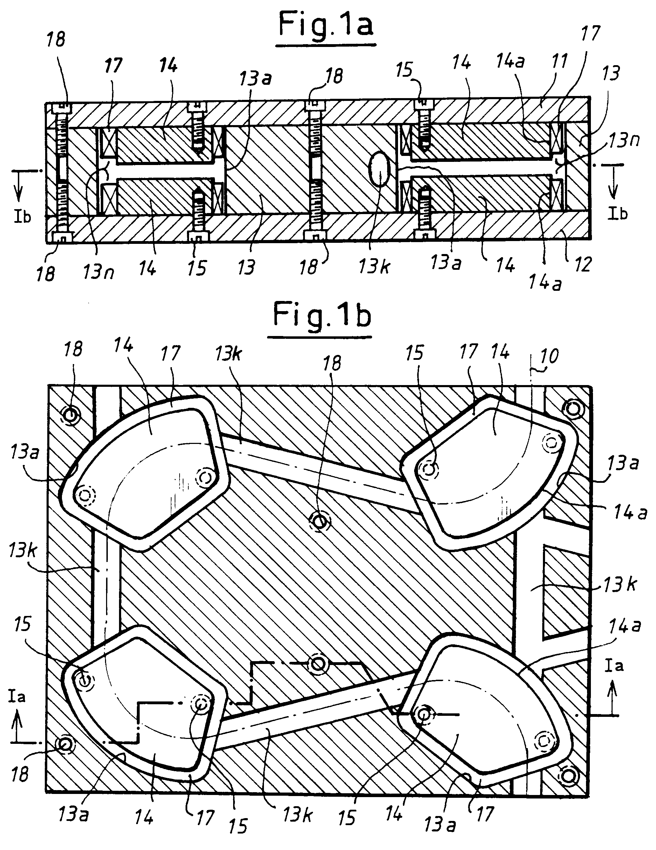

Die Figuren 1a und b zeigen dasselbe Elektronenenergiefilter in zwei verschiedenen Schnitten. Es ist aus zwei äußeren Platten (11, 12) und einer inneren Platte (13) sandwichartig zusammengesetzt. In Figur 1b läuft die Achsenlinie des Elektronenstrahles (10) in der Zeichenebene; in Figur 1a läuft sie in der zur Zeichenebene senkrechten Ebene, welche durch die Mitte der Platte (13) geht.

Die Polschuhe (14) sind auf die Innenseiten der Außenplatten (11, 12) aufgesetzt und an diesen z.B. mit Schrauben (15) befestigt. Die Polschuhe (14) können daher paarweise hergestellt werden, so daß trotz ihres komplizierten Querschnittes ihre Außenkanten (14a) genau übereinstimmen. Bei der Montage des Filters werden nach der Befestigung der Polschuhe (14) an den Außenplatten (11, 12) zunächst die Stromspulen (17) um die Polschuhe (14) gelegt und anschließend die Außenplatten (11, 12) auf die Innenplatte (13) aufgesetzt und z.B. mit Schrauben (18) befestigt.

Vor der Montage werden aus der Innenplatte (13) Aussparungen (13a) herausgefräst, die so dimensioniert sind, daß sich im montierten Zustand zwischen den Polschuhen (14) und der Innenplatte (13) die Nuten (13n) für die Stromspulen (17) ergeben. Außerdem sind in die Innenplatte (13) Kanäle (13k) gebohrt worden, in denen der Elektronenstrahl zwischen den Polschuhpaaren magnetisch abgeschirmt geradlinig verläuft.

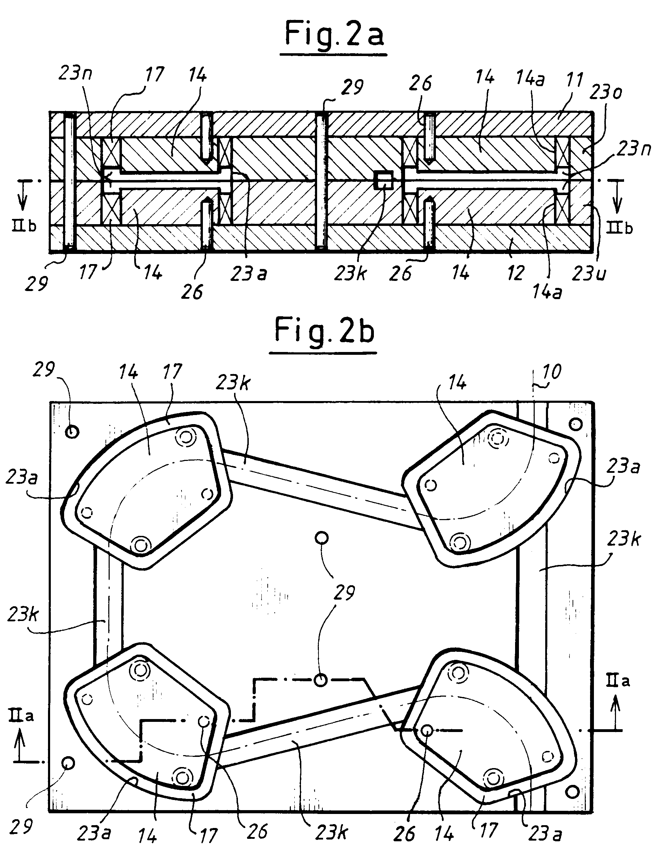

Ein besonders vorteilhafter Aufbau des Elektronenenergiefilters ist in den Figuren 2a und 2b dargestellt. Dort besteht der innere Teil des Filters aus zwei Innenplatten (23o, 23u). Die Kanäle (23k) zwischen den Polschuhpaaren können daher durch Fräsen hergestellt werden, was herstellungstechnisch einfacher ist als die Bohrungen (13k) in Figur 1. Auch bei diesem Aufbau sind die Polschuhe (14) auf die Innenseiten der Außenplatten (11, 12) aufgesetzt und an diesen befestigt, so daß sie ebenfalls paarweise hergestellt werden können. Für eine genaue Positionierung der Polschuhe können Paßstifte (26) verwendet werden. Entsprechende Paßstifte (29) können auch für eine genaue Positionierung der Außenplatten (11, 12) und der Innenplatten (23o, 23u) zueinander verwendet werden.

Auch in diesem Fall werden die Aussparungen (23a) in den Innenplatten (23o, 23u) so dimensioniert, daß sich im montierten Zustand zwischen den Polschuhen (14) und den Innenplatten (23o, 23u) die Nuten (23n) für die Stromspulen (17) ergeben. Bei der Montage des Elektronenenergiefilters werden zunächst ebenfalls die Polschuhe (14) an den Außenplatten (11, 12) befestigt. Anschließend wird auf jede Außenplatte (11, 12) die zugehörige Innenplatte (23o, 23u) aufgesetzt und die Stromspulen (17) eingelegt. Zum Schluß werden die beiden Hälften des Filters zusammengesetzt.

Selbstverständlich ist es auch möglich, z.B. drei Innenplatten zu verwenden, wobei die mittlere Platte die Höhe der Kanäle bzw. den Abstand der Polschuhoberflächen hat, so daß die Kanäle und die Aussparungen für die Polschuhe nicht aus den anderen Platten gefräst werden müssen.

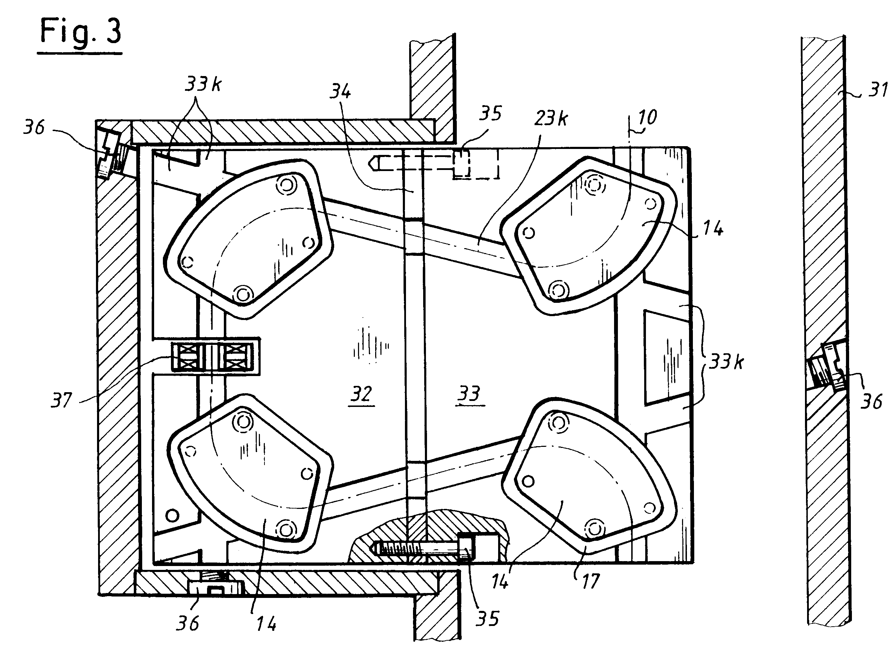

Die Figur 3 zeigt ein in die Säule (31) eines Elektronenmikroskopes eingesetztes Elektronenenergiefilter, bei dem die Innenplatten aus zwei Bereichen (32) und (33) bestehen, die durch einen Spalt (34) getrennt sind. Letzterer besteht aus einem nichtmagnetischen Material, z.B. Bronze. Die beiden Platten (32) und (33) sind durch Schrauben (35) fest miteinander verbunden. Ein derartiger Aufbau hat vor allen herstellungstechnische Vorteile. Es ist möglich, senkrecht zu dem Spalt (34) einen weiteren (nicht gezeichneten) Spalt vorzusehen, so daß insgesamt vier Bereiche mit je einem Polschuhpaar vorhanden sind.

Zwischen den zweiten und dritten Polschuhpaar ist in der Mitte ein Hexapol (37) angeordnet, der in bekannter Weise zur Verbesserung der Abbildungseigenschaften des Elektronenenergiefilters dient. Es hat sich herausgestellt, daß es sowohl für die Abbildungseigenschaften als auch für Justierzwecke vorteilhaft ist, dem Hexapolfeld ein Quadrupolfeld zu überlagern, welches durch Zusatzwicklungen auf den Spulen des Hexapols erzeugt wird.

Es ist außerdem vorteilhaft, die Kanäle (23k) bis an die äußeren Begrenzungen der Platten durch Verlängerungskanäle (33k) auszubilden. Dann können für Justier- oder Meßzwecke die Verschlußteile (36) durch Leuchtschirme oder andere Detektionssysteme ersetzt werden.

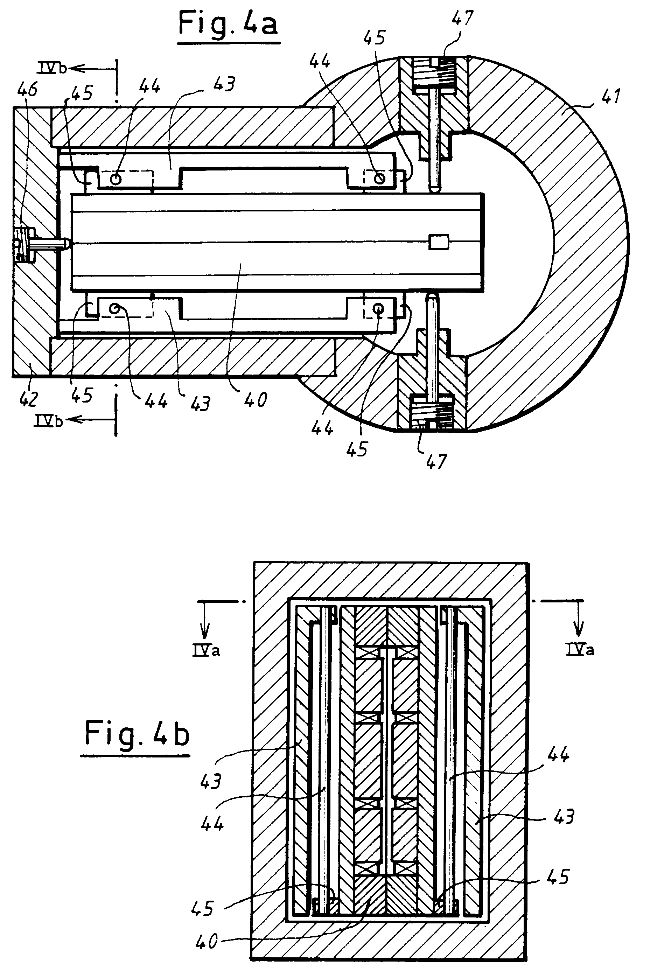

In den Figuren 4a und 4b ist die Befestigung des Elektronenenergiefilters in einem Elektronenmikroskop dargestellt. Das Filter (40) hängt als Funktionseinheit in einer Parallelogrammführung, die an dem Flansch (42) befestigt ist; es kann daher mit diesem aus der Säule (41) des Elektronenmikroskopes herausgenommen werden. Am Flansch (42) ist ein zweiteiliger Rahmen (43) befestigt, in dem oben vier Rundstäbe (44) eingespannt sind. Diese Stäbe sind an ihrem anderen Ende über Zwischenstücke (45) mit dem Filter (40) verbunden, welches infolge der Elastizität der Rundstäbe (44) mittels der Verstelleinrichtungen (46) und (47) zur optischen Achse des Elektronenstrahlgerätes justiert werden kann.

## Patentansprüche

1. Elektronenenergiefilter aus plattenförmigen Teilen mit Polschuhen (14), die von Nuten (13n) für die Stromspulen (17) begrenzt sind, und mit Kanälen (13k) in Abschirmbereichen zwischen den Polschuhen (14), dadurch gekennzeichnet, daß zwei Außenplatten (11,12) und eine Innenplatte (13) sandwichartig zusammengesetzt sind, daß die Polschuhe (14) auf die Innenseiten der Außenplatten (11, 12) aufgesetzt und an diesen befestigt sind, daß die Innenplatte (13) Aussparungen (13a) für die Polschuhe (14) hat, die so dimensioniert sind, daß sich zwischen den Polschuhen (14) und der Innenplatte (13) die Nuten (13n) für die Stromspulen (17) ergeben und daß die Kanäle (13k) als Bohrungen in der Innenplatte (13) hergestellt sind.

2. Elektronenenergiefilter aus plattenförmigen Teilen mit Polschuhen (14), die von Nuten (23n) für die Stromspulen (17) begrenzt sind, und mit Kanälen (23k) in Abschirmbereichen zwischen den Polschuhen (14), dadurch gekennzeichnet, daß zwei Außenplatten (11, 12) und mindestens zwei Innenplatten (23o, 23u) sandwichartig zusammengesetzt sind, daß die Polschuhe (14) auf die Innenseiten der Außenplatten (11, 12) aufgesetzt und an diesen befestigt sind, daß die Innenplatten (23o, 23u) Aussparungen (23a) für die Polschuhe (14) haben, die so dimensioniert sind, daß sich zwischen den Polschuhen (14) und den Innenplatten (23o, 23u) die Nuten (23n) für die Stromspulen (17) ergeben und daß die Kanäle (23k) in die einander zugewandten Seiten der Innenplatten (23o, 23u) gefräst sind.

3. Elektronenenergiefilter nach Anspruch 1 oder 2, dadurch gekennzeichnet, daß die Außenplatten (11, 12) und/oder die Innenplatte (13) bzw. Innenplatten (23o, 23u) durch einen oder zwei Spalte (34) aus nichtmagnetischem Material in zwei oder vier Bereiche (32, 33) geteilt sind.

4. Elektronenenergiefilter nach einem der Ansprüche 1 bis 3, dadurch gekennzeichnet, daß in der Mitte zwischen dem zweiten und dritten Polschuhpaar ein Hexapol (37) angeordnet ist, dessen Feld mit Hilfe von Zusatzwicklungen ein Quadrupolfeld überlagert ist.

5. Elektronenenergiefilter nach einem der Ansprüche 1 bis 4, dadurch gekennzeichnet, daß die Kanäle (23k) zwischen den Polschuhen (14) bis an die äußere Begrenzung der Innenplatte (13) bzw. der Innenplatten (23o, 23u, 32, 33) durch Verlängerungskanäle (33k) weitergeführt sind und daß in der Nähe der äußeren Begrenzung Leuchtschirme oder Detektionssysteme für Justier- oder Meßzwecke anbringbar sind.

6. Elektronenenergiefilter nach einem der Anpsrüche 1 bis 5, dadurch gekennzeichnet, daß die Stromspulen (17) Haupt- und Nebenwicklungen besitzen, wobei die Hauptwicklungen in Reihe geschaltet sind und die Nebenwicklungen nach Bedarf einzeln oder in Kombination geschaltet sind.

7. Elektronenenergiefilter nach einem der Ansprüche 1 bis 6, dadurch gekennzeichnet, daß es als Funktionseinheit (40) an einem Vakuumflansch (42) justierbar befestigt und mit diesem in ein Korpuskularstrahlgerät (41) einsetzbar ist.

8. Elektronenenergiefilter nach Anspruch 7, dadurch gekennzeichnet, daß die Funktionseinheit (40) über eine Parallelogrammführung (43, 44, 45) mit dem Vakuumflansch (42) verbunden ist.

9. Elektronenenergiefilter nach Anspruch 8, dadurch gekennzeichnet, daß die Parallelogrammführung (43, 44, 45) mit Rundstäben (44) ausgeführt ist.

10. Elektronenenergiefilter nach Anspruch 7, dadurch gekennzeichnet, daß die Funktionseinheit (40) über kreuztischartig angeordnete Verstelleinrichtungen mit dem Vakuumflansch (42) verbunden ist.

## Claims

1. Electron energy filter of plate-shaped parts having pole pieces (14) bounded by slots (13n) for the current coils (17) and having channels (13k) in shielding regions between the pole pieces (14), characterized by the fact that two outer plates (11, 12) and one inner plate (13) are assembled in a sandwich-like configuration, that the pole pieces (14) are seated on the inner sides of the outer plates (12) and attached thereat, that the inner plate (13) comprises cutouts (13a) for the pole pieces (14) which are dimensioned so that the slots (13n) for the current coils are formed between the pole pieces (14) and the inner plate (13) and that the channels (13k) are formed as bores within the inner plate (13).

2. Electron energy filter of plate-shaped parts having pole pieces (14) bounded by slots (23n) for the current coils (17) and having channels (23k) in shielding regions between the pole pieces (14), characterized by the fact that two outer plates (11, 12) and at least two inner plates (23o, 23u) are assembled in a sandwich-like configuration, that the pole pieces (14) are seated on the inner sides of the outer plates (11, 12) and attached thereat, that the inner plates (23o, 23u) comprise cutouts (23a) for the pole pieces (14) which are dimensioned so that the slots (23n) for the current coils (17) are formed between the pole pieces (14) and the inner plates (23o, 23u) and that the channels (23k) are milled into the adjacent surfaces of the inner plates (23o, 23u).

3. Electron energy filter of claim 1 or 2, characterized by the fact that the outer plates (11, 12) and/or the inner plate (13) or the inner plates (23o, 23u) are separated by one or two gaps (34) of nonmagnetic material into two or four regions (32, 33).

4. Electron energy filter of one of the claims 1 to 3, characterized by the fact that a hexapole (37) is arranged at the centre between the second and third pair of pole pieces, the field of which hexapole a quadrupole field is superimposed by means of additional windings.

5. Electron energy filter of one of the claims 1 to 4, characterized by the fact that the channels (23k) between the pole pieces (14) are extended to the outer boundary of the inner plate (13) or inner plates (23o, 23u, 32, 33) by extension channels (33k) and that fluorescent screens or detection systems are attachable in the neighbourhood of the outer boundary for adjustment or measurement purposes.

6. Electron energy filter of one of the claims 1 to 5, characterized by the fact that the current coils (17) comprise primary windings and secondary windings, whereby the primary windings are serially connected and whereby the secondary windings, as required, are connected individually or in combination.

7. Electron energy filter of one of the claims 1 to 6, characterized by the fact that the filter is adjustably attached as a functional unit (40) to a vacuum flange (42) and can be seated in a corpuscular beam apparatus (41) together with this vacuum flange (42).

8. Electron energy filter of claim 7, characterized by the fact that the functional unit (40) is attached to the vacuum flange (42) via a parallelogram guiding (43, 44, 45).

9. Electron energy filter of claim 8, characterized by the fact that the parallelogram guiding (43, 44, 45) comprises round rods (44).

10. Electron energy filter of claim 7, characterized by the fact that the functional unit (40) is attached to vacuum flange (42) via an x-y-table.

## Revendications

1. Filtre d'énergie électronique composé d'éléments en forme de plaque et comprenant des pièces polaires (14) délimitées par des rainures (13n) réservées aux bobines ampèremétriques (17), ainsi que des canaux (13k) aménagés dans les zones blindées séparant les pièces polaires (14), caractérisé en ce que deux plaques extérieures (11,12) et une plaque intérieure (13) sont assemblées en sandwich, en ce que les pièces polaires (14) sont posées et fixées sur les faces intérieures des plaques extérieures (11, 12), en ce que la plaque intérieure (13) est munie d'évidements qui sont destinés à recevoir les pièces polaires (14) et qui sont dimensionnés de manière à former entre les pièces polaires (14) et la plaque intérieure (13) les rainures (13n) réservées aux bobines ampèremétriques (17) et en ce que les canaux (13k) sont formés par des alésages pratiqués dans la plaque intérieure (13).

2. Filtre d'énergie électronique composé d'éléments en forme de plaque et comprenant des pièces polaires (14) délimitées par des rainures (23n) réservées aux bobines ampèremétriques (17), ainsi que des canaux (23k) aménagés dans les zones blindées séparant les pièces polaires (14), caractérisé en ce que deux plaques extérieures (11,12) et au moins deux plaques intérieures (23o, 23u) sont assemblées en sandwich, en ce que les pièces polaires (14) sont posées et fixées sur les faces intérieures des plaques extérieures (11, 12), en ce que les plaques intérieures (23o, 23u) sont munies d'évidements (23a) qui sont destinés à recevoir les pièces polaires (14) et qui sont dimensionnés de manière à former entre les pièces polaires (14) et les plaques intérieures (23o, 23u) les rainures (23n) réservées aux bobines ampèremétriques (17) et en ce que les canaux (23k) sont fraisés dans les deux côtés des plaques intérieures (23o, 23u) qui se font face.

3. Filtre d'énergie électronique selon la revendication 1 ou 2, caractérisé en ce que les plaques extérieures (11, 12) et/ou la plaque intérieure (13) ou les plaques intérieures (23o, 23u) sont subdivisées en deux ou quatre zones (32, 33) par une ou deux fentes (34) remplies d'un matériau non magnétique.

4. Filtre d'énergie électronique selon l'une quelconque des revendications 1 à 3, caractérisé en ce qu'un champ quadrupolaire est superposé, à l'aide d'enroulements auxiliaires, au champ d'un hexapôle (37) disposé au milieu entre la deuxième et la troisième paire de pièces polaires.

5. Filtre d'énergie électronique selon l'une quelconque des revendications 1 à 4, caractérisé en ce que les canaux (23k) disposés entres les pièces polaires (14) sont prolongés jusqu'au bord extérieur de la plaque intérieure (13) ou des plaques intérieures (23o, 23u, 32, 33) par des canaux de pontage (33k) et en ce que des écrans fluorescents ou des détecteurs utilisés à des fins de mesure ou d'ajustage sont adaptables à proximité dudit bord extérieur.

6. Filtre d'énergie électronique selon l'une quelconque des revendications 1 à 5, caractérisé en ce que les bobines ampèremétriques (17) possèdent des enroulements principaux et des enroulements secondaires, les premiers étant couplés en série et les seconds pouvant être connectés individuellement ou en combinaison.

7. Filtre d'énergie électronique selon l'une quelconque des revendications 1 à 6, caractérisé en ce qu'il peut former un ensemble fonctionnel (40) qui est monté de manière ajustable sur une bride à vide et qui peut être intégré avec celle-ci à un appareil à rayonnement corpusculaire (41).

8. Filtre d'énergie électronique selon la revendication 7, caractérisé en ce que l'ensemble fonctionnel (40) est relié à la bride à vide (42) par l'intermédiaire d'un système de guidage en parallélogramme (43, 44, 45).

9. Filtre d'énergie électronique selon la revendication 8, caractérisé en ce que le système de guidage en parallélogramme (43, 44, 45) est exécuté sous forme d'un assemblage de bâtons ronds (44).

10. Filtre d'énergie électronique selon la revendication 7, caractérisé en ce que l'ensemble fonctionnel (40) est relié à la bride à vide (42) par l'intermédiaire de dispositifs de réglage disposés de façon analogue à une platine à mouvements croisés.
